# EUROPÄISCHE PATENTSCHRIFT

(11) **EP 1 721 176 B1**
(45) Veröffentlichungstag und Bekanntmachung des Hinweises auf die Patenterteilung: **01.09.2010**
(21) Anmeldenummer: 03795746.1
(22) Anmeldetag: 10.12.2003
(51) Int. Cl.: G01R 19/00

(54) **VERFAHREN UND VORRICHTUNG ZUR GLEICHSTROMVERSORGUNG EINES ELEKTRISCHEN VERBRAUCHERS**
METHOD AND DEVICE FOR SUPPLYING AN ELECTRIC CONSUMER WITH DIRECT CURRENT
PROCEDE ET DISPOSITIF D'ALIMENTATION EN COURANT CONTINU D'UN RECEPTEUR ELECTRIQUE

(43) Veröffentlichungstag der Anmeldung: 15.11.2006
(73) Patentinhaber: ROBERT BOSCH GMBH, 70442 Stuttgart (DE)
(72) Erfinder: GADEMANN, Lothar, 72108 Rottenburg (DE); JACOB, Wolfgang, 72160 Horb (DE); KOTTHAUS, Stefan, 76547 Sinzheim (DE)
(86) Internationale Anmeldenummer: PCT/DE2003/004067
(87) Internationale Veröffentlichungsnummer: WO 2005/062062

(56) Entgegenhaltungen:
- WO-A-99/21279
- DE-A- 10 135 169
- DE-A- 19 906 276
- US-A- 6 028 426
- US-A1- 2003 011 355
- US-A1- 2003 155 930
- US-A1- 2003 165 072
- PATENT ABSTRACTS OF JAPAN Bd. 2003, Nr. 12, 5. Dezember 2003 (2003-12-05) & JP 2003 235268 A (NISSAN MOTOR CO LTD), 22. August 2003 (2003-08-22)

## Beschreibung

### Stand der Technik

Die Erfindung geht aus von einem Verfahren nach Anspruch 1 und einer Vorrichtung nach Anspruch 6 zur Gleichstromversorgung eines elektrischen Verbrauchers, vorzugsweise eines über einer Halbleiter-Leistungsendstufe elektronisch kommutierbaren Elektromotors, wie sie aus der De 44 22 083 A bekannt geworden sind. In dieser Druckschrift ist ein Verfahren zur Drehzahl- und/oder Wegstreckenmessung eines Kommutatormotors beschrieben, bei dem die Welligkeit des Stromes als Steuergröße für den Kommutierungsvorgang mit Hilfe eines Netzwiderstandes im Motorstromkreis ermittelt und die über dem Netzwiderstand abfallende Spannung als Regelgröße verwendet wird. Über die spezielle Ausführung des als Netzwiderstand verwendeten Shunt enthält die Druckschrift keine Ausführungen.

Details zur Integration eines Shuntwiderstands in einem Stromkreis und zur Temperaturkompensation finden sich in den Dokumenten JP 20032353268, US 20030165072, DE 10135169.

Erfindungsgemäß wird als Messgröße für den Verbraucherstrom ein Spannungsabfall im Verbraucherstromkreis oder am Verbraucher selbst verwendet, wobei der gemessene Spannungsabfall an diesem Widerstand anschließend durch eine Temperaturkompensation an den Wert des Spannungsabfalls an einem Referenzwiderstand mit sehr geringem Temperaturkoeffizient angeglichen wird. Die Temperaturkompensation der Messgröße erfolgt hierbei zweckmäßigerweise rechnerisch in einem Mikroprozessor, während die Überstromabschaltung vorzugsweise hardwaremäßig bei Erreichen eines vorgegebenen, zyklisch an die Temperatur des Referenzwiderstandes angepassten Spannungsabfalls durchgeführt wird.

Als vorteilhaft hat es sich erwiesen, wenn zumindest die Messung des Widerstandwertes des als Referenzwiderstand verwendeten Teils der Schaltung und die zugehörige Referenztemperatur an jeder einzelnen Verbrauchereinheit erfolgt, und zwar vorzugsweise während der Herstellung der Schaltung. Auf diese Weise können die veränderlichen relevanten Größen des Verfahrens, insbesondere die Fertigungstoleranzen des Referenzwiderstandes, sehr exakt mit vertretbarem Aufwand ermittelt werden, während andere, weniger schwankende oder weniger streuende Messgrößen typenmäßig oder stichprobenartig außerhalb des Fertigungsprozesses bestimmt werden können.

Zweckmäßigerweise sind bei der erfindungsgemäßen Schaltungsanordnung sowohl der zur Bestimmung des Spannungsabfalls verwendete Referenzwiderstand als auch ein Sensor zu dessen Temperaturerfassung mit dem gleichen Kühlkörper verbunden, wobei mit guter Näherung die Temperatur des Kühlkörpers als Referenztemperatur herangezogen werden kann. Die zur Temperaturkompensation der Messwerte am Referenzwiderstand ermittelten Größen werden zweckmäßigerweise dann in einem nichtflüchtigen Speicher abgelegt, vorzugsweise in einem nichtflüchtigen Speicher des zur Durchführung der Kompensation verwendeten Mikroprozessors.

Eine besonders vorteilhafte und kostengünstig aufgebaute gattungsgemäße Vorrichtung zur Gleichstromversorgung eines elektrischen Verbrauchers zeichnet sich dadurch aus, dass als Referenzwiderstand ein Teil des Verbraucherstromkreises oder der Verbraucher selbst dient, und dass dem Referenzwiderstand eine Anordnung zur Temperaturkompensation zugeordnet ist, welche aus dem gemessenen Spannungsabfall am Referenzwiderstand unter Berücksichtigung seiner Temperatur den tatsächlichen Verbraucherstrom ermittelt und beim Auftreten eines vorgebbaren Überstroms den Verbraucher abschaltet oder zumindest die zugeführte Leistung reduziert. Als Referenzwiderstand besonders geeignet ist ein Abschnitt einer bei einer gattungsgemäßen Gleichstromversorgung häufig als Stromzuführung verwendeten Stanzgitterbahn des Verbraucherstromkreise, welche vorzugsweise im Messbereich zusätzlich mit einer Querschnittsverjüngung versehen wird zur Bereitstellung einer ausreichenden Referenzspannung.

Dem Referenzwiderstand wird zweckmäßigerweise räumlich und thermisch sehr eng ein Temperatursensor zugeordnet, vorzugsweise in der Art, dass sowohl der Referenzwiderstand als auch der Temperatursensor thermisch und mechanisch mit ein und demselben Kühlkörper verbunden und eng beieinander angeordnet sind. Die temperaturkompensierte Ausgangsspannung für die Steuerung kann dann von einem Mikroprozessor geliefert werden, mit dem die Ausgänge des Referenzwiderstandes und des Temperatursensors verbunden sind. Hierbei ist vorteilhafterweise der Ausgang des Referenzwiderstandes zusätzlich über einen Verstärker für die Referenzspannung mit dem Mikroprozessor verbunden, um eine ausreichende Referenzspannung sicherzustellen. Eine erste Möglichkeit zur Überwachung und Steuerung des Verbraucherstromes besteht dann darin, dass der Mikroprozessor unmittelbar die Signale für die Steuerung des Verbrauchers liefert: Da jedoch Stromspitzen im Verbraucherstromkreis sehr kurzfristig auftreten können und andererseits der Zyklus der vom Mikroprozessor gelieferten Signale nicht beliebig verkürzt werden kann, ist es vorteilhaft, das Ausgangssignal des Verstärkers für die Referenzspannung über einen Komparator direkt mit der Verbrauchersteuerung zu verbinden, wobei dem zweiten Eingang des Komparators ein sich zeitlich nur langsam veränderndes Signal der Referenztemperatur am Referenzwiderstand zugeführt wird, wodurch die Steuerung für den Verbraucherstromkreis vom Rechenzyklus des Mikroprozessors entkoppelt wird. Als zweite Eingangsgröße für den zur Steuerung des Verbraucherstromkreises benutzten Komparators kann hierbei die temperaturkompensierte Ausgangsspannung des Mikroprozessors entweder als pulsweitenmodulierte Gleichspannung, vorzugsweise über einen Tiefpass, oder als analoge Gleichspannung ausgegeben werden, wobei der Ausgang des Mikrocomputers direkt mit dem Eingang des Komparators verbunden ist, welcher in beiden Fällen beim Auftreten einer Überspannung am Referenzwiderstandes sofort das Ausgangssignal für die Steuerung des Verbraucherstromkreises liefert.

Weitere Einzelheiten und vorteilhafte Weiterbildungen der Erfindung ergeben sich aus den Unteransprüchen und den Ausführungsbeispielen der Erfindung.

Die Zeichnungen zeigen in
Figur 1 den Schaltungsaufbau einer erfindungsgemäßen Gleichstromversorgung eines elektronisch kommutierbaren Elektromotors,
Figur 2 eine Darstellung der thermischen und räumlichen Zuordnung eines als Referenzwiderstand verwendeten Teil des Verbraucherstromkreises mit zugeordnetem Temperatursensor auf einem Kühlkörper,
Figur 3 eine erste Schaltungsanordnung mit einer direkten Steuerung des Verbraucherstromkreises durch einen Mikroprozessor,
Figur 4 eine zweite Schaltungsanordnung mit einem dem Verbraucherstromkreis vorgeschalteten Komparator und pulsweitenmoduliertem Temperatur- Kompensationssignal vom Mikroprozessor, und
Figur 5 eine dritte Schaltungsanordnung mit dem Verbraucherstromkreis vorgeschaltetem Komparator und analogem Temperatur-Kompensationssignal des Mikroprozessors.

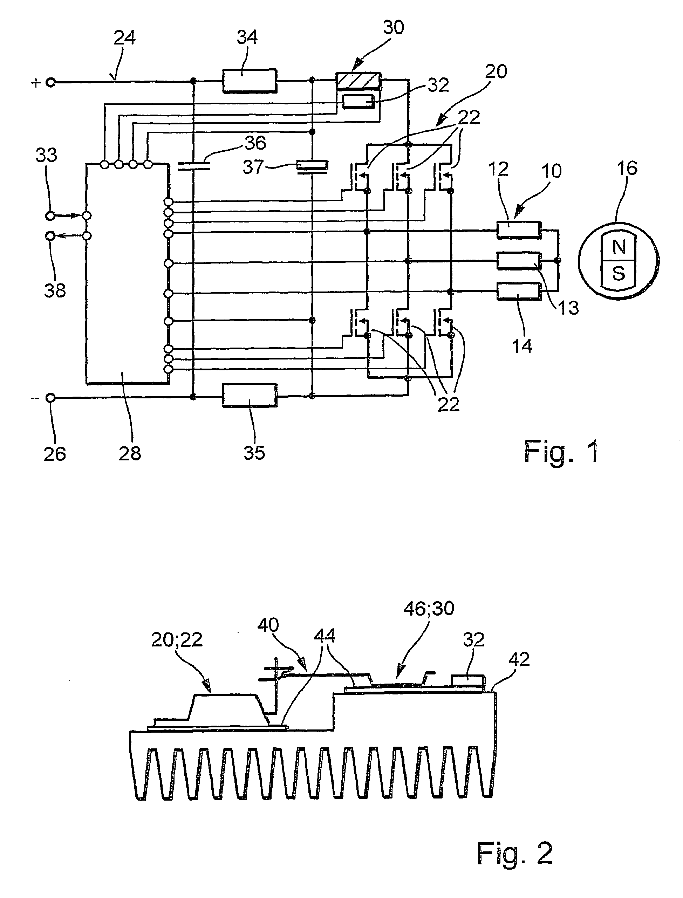

In Figur 1 ist ein Schaltungsaufbau mit einer Gleichstromversorgung eines elektronisch kommutierbaren Elektromotors 10 dargestellt, dessen Stator drei in Stern geschaltete Wicklungen 12,13 und 14 trägt. Der permanentmagnetische Rotor des Elektromotors 10 ist mit 16 bezeichnet. Die Stromversorgung der Wicklungen 12,13 und 14 erfolgt über eine Leistungsendstufe 20, welche mit MOSFETs als Schaltelementen in einer B6-Anordnung in bekannter Weise aufgebaut ist. Die Stromversorgung des Elektromotors 10 erfolgt über einen Verbraucherstromkreis 24 von einer Gleichstromquelle 26. Hierbei sind die in Figur 1 stärker gezeichneten Verbindungsleitungen im Verbraucherstromkreis 24 als Stanzgitterbahnen ausgeführt.

Als Ansteuerlogik für die Leistungsendstufe 20 des Elektromotors 10 dient ein Mikroprozessors 28. Dabei wird als Messelement für den Verbraucherstrom ein als Referenzwiderstand 30 ausgebildeter Teil des Verbraucherstromkreises 24 benutzt. Beim Ausführungsbeispiel handelt es sich dabei um einen im Querschnitt verringerten Abschnitt der Stanzgitterbahn des Verbraucherstromkreises 24. Ein Temperatursensor 32 dient zur Erfassung der Temperatur des Referenzwiderstandes. Die Anschlüsse des Referenzwiderstandes 30 und des Temperatursensors 32 sind mit Eingängen des Mikroprozessors 28 verbunden. Weitere Eingangssignale erhält der Mikroprozessor 28 über einen Signaleingang 33 sowie von den Anschlusspunkten der Statorwicklungen 12,13 und 14 an den Verbraucherstromkreis 24 zwischen den Schaltelementen 22 der Leistungsendstufe 20.

Als Entstörkomponenten sind dem Elektromotor 10 zwei Entstördrosseln 34 und 35 in den Zuleitungen zur Gleichstromquelle 26 sowie zwei Entstörkondensatoren 36 und 37 beidseitig zwischen den Anschlüssen der Entstördrosseln 34 und35 zugeordnet. Bei dem Entstörkondensator 37 handelt es sich um einen Elektrolytkondensator, der Entstörkondensator 36 ist als Folienkondensator ausgebildet. Die Spannung am Entstörkondensator 37 ist ebenfalls dem Mikroprozessor 38 zugeführt. Die Entstörung des Elektromotors 10 ist in Figur 1 nur der Vollständigkeit halber dargestellt, sie steht nicht direkt im Zusammenhang mit der vorliegenden Erfindung. Schließlich ist mit der Bezugsziffer 38 noch ein Signalausgang des Mikroprozessors 28 bezeichnet.

Die Steuerung des Elektromotors 10 erfolgt über die Leistungsendstufe 20 in herkömmlicher Weise durch sukzessives Bestromen der Statorwicklungen 12,13 und 14 entsprechend der Stellung des Rotors 16, wobei die Ansteuersignale für die Schaltelemente 22 vom Mikroprozessor 28 geliefert werden. An die Stelle dieser elektronischen Kommutierung könnte jedoch auch eine Rotorsteuerung mit Bürsten und Kommutator treten, für die Erfindung ist die Kommutierungsart des Motors unbeachtlich. Gegenstand der vorliegenden Erfindung ist vielmehr die spezielle Art der Erfassung des Verbraucherstromes mit Hilfe des Referenzwiderstandes 30 und des Temperatursensors 32, wobei die Stromerfassung einerseits zur Drehzahlregelung, im vorliegenden Fall aber auch insbesondere zur Begrenzung der Leistung des Elektromotors 10 dient.

Um eine exakte Stromerfassung mit Hilfe eines Referenzwiderstandes im Verbraucherstromkreis 24 zu gewährleisten, ist es erforderlich, dass der Referenzwiderstand einen sehr geringen Temperaturkoeffizienten aufweist, um Temperatureinflüsse auf das Messergebnis weitestgehend auszuschließen. Dies wird beim Anmeldungsgegenstand dadurch erreicht, dass einem von Hause aus temperaturabhängigen Referenzwiderstand ein Temperatursensor zugeordnet wird, welcher als Korrekturwert für den gemessenen Spannungsabfall am Referenzwiderstand 30 ein Kompensationssignal liefert, mit dessen Hilfe der Wert des Spannungsabfalls am Referenzwiderstand auf den von Temperatureinflüssen bereinigten Wert korrigiert und der tatsächlich im Verbraucherstromkreis 24 fließende Strom ermittelt werden kann. Auf diese Weise können sowohl Temperatureinflüsse ausgeschaltet werden, welche beispielsweise durch benachbarte Wärmequellen sowie die Umgebungstemperatur verursacht sind, zum anderen aber auch die Temperatureinflüsse auf Grund der im Referenzwiderstand 30 in Wärme umgesetzten Verlustleistung. Auf Einzelheiten der Anordnung und deren Wirkungsweisen wird bei der Beschreibung der folgenden Figuren näher eingegangen.

Figur 2 zeigt die Gestaltung der Schaltungsanordnung gemäß Figur 1 im Bereich des Referenzwiderstandes 30 und des Temperatursensors 32, wobei als Referenzwiderstand ein Abschnitt 46 einer Stanzgitterbahn 40 des Verbraucherstromkreises 24 benutzt ist. Als Träger dient ein Kühlkörper 42, auf welchen unter Zwischenlage eines elektrisch isolierenden Wärmeleitmediums 44 die Leistungsendstufe 20 mit den Schaltelementen 22, der Abschnitt 46 des Stanzgitters 40 und der Temperatursensor 32 aufgebracht sind. Wegen der guten Wärmeleitfähigkeit des elektrisch isolierenden Mediums 44 nehmen somit das Stanzgitter 40, insbesondere sein den Referenzwiderstand 30 bildender Abschnitt 46 wie auch der Temperatursensor 32 mit sehr guter Näherung die Temperatur des Kühlkörpers 42 und somit die gleiche Referenztemperatur an. An die Stelle des Stanzgitters 40 könnte jedoch alternativ auch eine Leiterplatte mit ausreichender Kupferschichtdicke oder eine entsprechend gestaltete Stromschiene treten. Die MOSFETs 22 der Leistungsendstufe 20 werden ebenfalls über eine Schicht des isolierenden Wärmeleitmediums 44 thermisch an den Kühlkörper angebunden. Die mechanische Befestigung der verschiedenen Elemente am Kühlkörper 42 ist in Figur 2 nicht dargestellt, sie kann beispielsweise durch Kleben, aber auch mechanisch durch Schrauben oder Federn erfolgen. Die Position des Referenzwiderstandes 30, beziehungsweise des entsprechenden Abschnitts 46 der Stanzgitterbahn 40, innerhalb der Schaltungsanordnung gemäß Figur 1 ist dabei weitgehend frei wählbar, beispielsweise also auch im Massezweig oder jeweils in den einzelnen Phasen der Wicklung oder den Zuleitungen zu den Schaltelementen 22 der Leistungsendstufe 20. Um als Referenzspannung dabei einen ausreichend hohen Spannungsabfall zu erzielen ist das Stanzgitter 40 im Bereich des Abschnittes 46 im Querschnitt verjüngt oder als Mäander ausgeführt. Durch die thermisch enge Anbindung des Referenzwiderstandes 30 an den Kühlkörper 42 wird erreicht, dass die Verlustleistung in diesem Bereich nicht zu einem wesentlichen Temperaturanstieg führt. Der Referenzwiderstand 30 und der Temperatursensor 32 sind räumlich nahe beieinander angeordnet. Als Temperatursensor 32 dient beispielsweise ein NTC oder PTC-Widerstand.

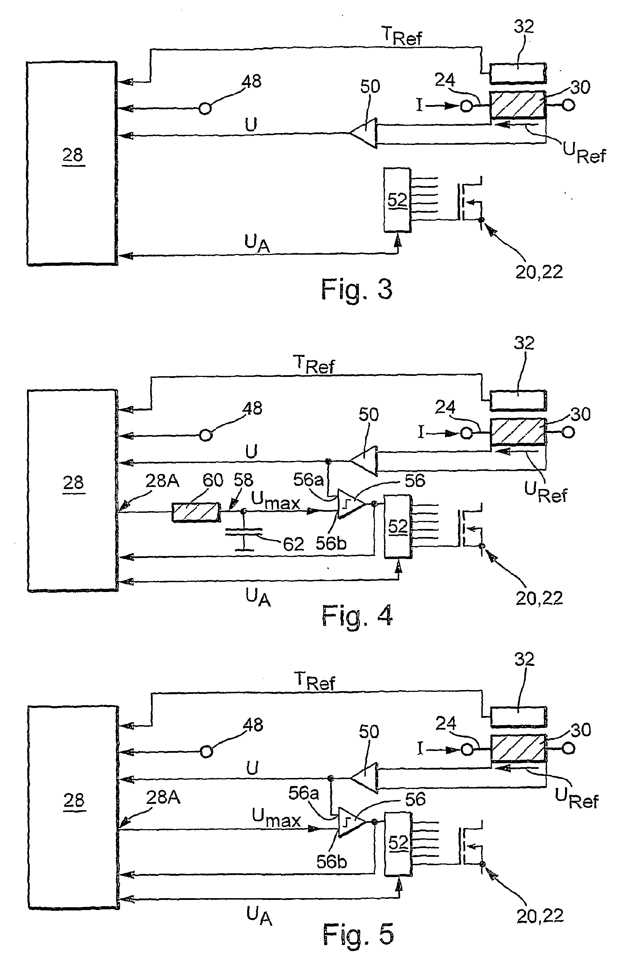

Abbildung 3 zeigt den erfindungsgemäß relevanten Teil der Schaltungsanordnung gemäß Figur 1 mit dem Referenzwiderstand 30, dem Temperatursensor 32 und dem Mikroprozessor 28 im Detail. Hierbei sind die Anschlüsse des Referenzwiderstandes 30 über einen zusätzlichen Verstärker 50 mit dem Mikroprozessor 28 verbunden, dem auch das Ausgangsignal des Temperatursensors 32 zugeführt ist. Durch einen Eingang 48 ist angedeutet, dass dem Mikroprozessor 28 weitere Eingangsgrößen zugeführt werden. Der Mikroprozessor ist ferner mit einem Endstufentreiber 52 der Leistungsendstufe 20 gekoppelt, welcher seinerseits die Schaltelemente 22 der Leistungsendstufe 20 aktiviert.

Sobald ein Strom durch den als Referenzwiderstand 30 ausgebildeten Abschnitt (46) des Verbraucherstromkreises 24 fließt, entsteht an diesem ein Spannungsabfall, welcher in dem Verstärker 50 verstärkt und dem Mikroprozessor 28 zugeführt wird. Die Temperaturkompensation der Messgrößen erfolgt bei dieser Ausführung rechnerisch im Mikroprozessor 28 auf Grund des vom Temperatursensor 32 gelieferten Messwertes, sodass der Mikroprozessor 28 den Endstufentreiber 52 mit Ansteuersignalen versorgt, auf welche der Temperaturkoeffizient des Referenzwiderstandes 30 praktisch keinen Einfluss mehr hat. Der thermische Widerstand im Bereich des Wärmeleitmediums 44 einerseits zwischen dem Abschnitt 46 des Stanzgitters 40 und andererseits zwischen dem Temperatursensor 32 und dem Kühlkörper 42 werden berücksichtigt. Einem maximal zulässigen Strom im Verbraucherkreis entspricht dann ein Schwellwert des Spannungsabfalls U am Referenzwiderstand 30. Die Ansteuersignale zwischen dem Mikroprozessor 28 und dem Endstufentreiber 52 sind durch die Spannung U_{A} symbolisiert. Die zur Temperaturkompensation am Referenzwiderstand 30 ermittelten Werte sind in einem nichtflüchtigen Speicher des Mikroprozessors 28 abgelegt.

Die Schaltungsanordnungen entsprechend den Figuren 4 und 5 stimmen grundsätzlich mit derjenigen aus Figur 3 überein, jedoch sind zur schnelleren Überstromabschaltung zusätzliche Maßnahmen getroffen. Bei der Anordnung gemäß Figur 3 kann eine Stromspitze unter Umständen nicht schnell genug abgeschaltet werden, weil der Mikroprozessor 28 nur zyklisch in einem bestimmten Zeitraster arbeitet, welches unter Umständen für die Abschaltung einer Stromspitze zu langsam ist. Aus diesem Grund ist in den Figuren 4 und 5 jeweils am Ausgang des Verstärkers 50 ein Komparator 56 angeschlossen, um auf einen Überstrom im Verbraucherstromkreis 24 sofort reagieren zu können. Hierzu wird einem ersten Eingang 56a des Komparators jeweils die verstärkte Referenzspannung vom Ausgang des Verstärkers 50 zugeführt, während dem anderen Eingang 56b des Komparators eine temperaturkompensierte Vergleichsspannung zugeführt wird, deren Anpassung in größeren Zeitabständen erfolgen kann, als sie für eine schnelle Abschaltung eines Überstroms erforderlich sind. Der Mikroprozessor 28 liefert den Schwellwert für die Referenzspannung, welcher einerseits von dem maximal zulässigen Strom im Verbraucherstromkreis und andererseits von der die Höhe des Spannungsabfalls bestimmenden Temperatur des Referenzwiderstandes 30 abhängt. Da der entsprechende Maximalstrom vorgegeben ist und sich die Temperatur am Referenzwiderstand 30 nicht sprungartig ändert, genügt eine Anpassung der temperaturkompensierten Ausgangsspannung für den Komparator 56 in größeren Zeitabständen, als sie für die Abschaltung von Stromspitzen erforderlich sind. Hierbei handelt es sich also um eine rein hardwaremäßige Überstromabschaltung bei Erreichen des vorgegebenen, in längeren Zyklen an die Temperatur des Referenzwiderstandes 30 angepassten Spannungsabfalls Uₘₐₓ. Die Ausgangsspannung des Komparators 56 ist das Steuersignal für die Abschaltung des Verbrauchers. Die Bereitstellung der temperaturkompensierten Ausgangsspannung Uₘₐₓ durch den Mikroprozessor 28 erfolgt bei der Anordnung gemäß Figur 4 in Form einer pulsweitenmodulierten Gleichspannung, wobei der Ausgang 28A des Mikroprozessors 28 zur Glättung der Ausgangsspannung über einen Tiefpass 58 mit einem Widerstand 60 und einem Kondensator 62 mit dem Eingang 56b des Komparators 56 verbunden ist. Alternativ hierzu kann gemäß Figur 5 der Mikroprozessor 28 an seinem Ausgang 28A als temperaturkompensierte Ausgangsspannung Uₘₐₓ eine analoge Gleichspannung liefern, welche dann direkt dem Eingang 56b des Komparators zugeführt wird.

Aus Gründen der Rationalisierung bei der Herstellung der Schaltungsanordnung, beziehungsweise der Programmierung des Mikroprozessors, erscheint es ausreichend, wenn nur die Messung des Widerstandswertes des als Referenzwiderstand 30 verwendeten Teils der Schaltung und die zugehörige Referenztemperatur an jeder einzelnen Verbrauchereinheit, im vorliegenden Fall also an jeder einzelnen Elektromotoreinheit erfolgt. Vorzugsweise geschieht dies im Verlauf der Herstellung der Schaltung, während die restlichen Messungen wie zum Beispiel das Erstellen der Kennlinie außerhalb der Fertigung, beispielsweise an Musterteilen durchgeführt werden.

Die erfindungsgemäße Temperaturkompensation des am Referenzwiderstand gemessenen Spannungsabfalls U_{Ref} kann entsprechend der Anordnung in Figur 3 also vollständig softwaremäßig im Mikroprozessor 28 durchgeführt werden, welcher dann auch unmittelbar die Steuersignale für die Leistungsendstufe 20 liefert. Alternativ erscheint es jedoch entsprechend den Anordnungen in den Figuren 4 und 5 vorteilhaft, wenn zumindest die Überstromabschaltung zur Verkürzung der Abschaltzeit hardwaremäßig mit Hilfe des Verstärkers 50 und des Komparators 56 und vorzugsweise des Tiefpasses 58 durchgeführt wird. Weiterhin alternativ ist es jedoch auch möglich, das Verfahren und die Vorrichtung vollständig hardwaremäßig zu realisieren mittels eines gesonderten Rechenwerks in einem ASIC.

## Patentansprüche

1. Verfahren zur Gleichstromversorgung eines elektrischen Verbrauchers (10), vorzugsweise eines über eine Halbleiter-Leistungsendstufe (20) elektronisch kommutierbaren Elektromotors (10), dessen Verbraucherstrom (I) entsprechend dem Spannungsabfall (URef) an einem Referenzwiderstand (30) bestimmt wird, wobei als Messgröße der Spannungsabfall (URef) im Verbraucherstromkreis (24) oder am Verbraucher (10) selbst verwendet wird, welcher anschließend durch eine Temperaturkompensation an den Wert des Spannungsabfalls an einem Referenzwiderstand mit sehr geringem Temperaturkoeffizienten angeglichen wird, **dadurch gekennzeichnet, dass** eine Überstromabschaltung hardwaremäßig (50, 52, 56) bei Erreichen eines vorgegebenen, zyklisch an die Temperatur des Referenzwiderstandes (30) angepassten Spannungsabfalls (Umax) erfolgt, wobei als Referenzwiderstand (30) ein Abschnitt (46) einer Stanzgitterbahn (40) des Verbraucherstromkreises (24) dient.

2. Verfahren nach Anspruch 1, **dadurch gekennzeichnet, dass** die Temperaturkompensation der Messgröße rechnerisch in einem Mikroprozessor (28) erfolgt.

3. Verfahren nach einem der vorhergehenden Ansprüche, **dadurch gekennzeichnet, dass** zumindest die Messung des Widerstandswertes des als Referenzwiderstand (30) verwendeten Teils der Schaltung und der zugehörigen Referenztemperatur (TRef) an jeder einzelnen Verbrauchereinheit erfolgt, vorzugsweise bei der Herstellung der Schaltung.

4. Verfahren nach Anspruch 3, **dadurch gekennzeichnet, dass** zur näherungsweisen Bestimmung der Temperatur (TRef) des Referenzwiderstandes (30) im Betrieb die Temperatur eines Kühlkörpers (42) gemessen wird, mit welchem der Referenzwiderstand (30) thermisch und mechanisch verbunden ist.

5. Verfahren nach einem der vorhergehenden Ansprüche, **dadurch gekennzeichnet, dass** die zur Temperaturkompensation am Referenzwiderstand (30) ermittelten Werte in einem nichtflüchtigen Speicher des Mikroprozessors (28) abgelegt werden.

6. Vorrichtung zur Gleichstromversorgung eines elektrischen Verbrauchers (10), vorzugsweise eines über eine Halbleiter-Leistungsendstufe (20) elektronisch kommutierbaren Elektromotors (10), mit einem Referenzwiderstand (30) im Verbraucherstromkreis zur Messung eines dem Verbraucherstrom (I) entsprechenden Spannungsabfalls (URef), insbesondere zur Durchführung des Verfahrens nach einem der Ansprüche 1 bis 5, wobei als Referenzwiderstand (30) ein Teil des Verbraucherstromkreises (24) oder der Verbraucher (10) selbst dient und wobei ein Mikroprozessor (28) vorgesehen ist zur Temperaturkompensation des Messwertes (URef) entsprechend dem Messwert an einem Referenzwiderstand mit sehr geringer Thermospannung, welcher aus dem gemessenen Spannungsabfall (URef) am Referenzwiderstand (30) des Verbraucherstromkreises (24) unter Berücksichtigung seiner Temperatur den tatsächlichen Verbraucherstrom (I) ermittelt, **dadurch gekennzeichnet, dass** dem Referenzwiderstand (30) ein Temperatursensor (32) zugeordnet ist, und dass die Ausgänge des Referenzwiderstandes (30) und des Temperatursensors (32) mit Eingängen des Mikroprozessors (28) verbunden sind, welcher eine zyklisch an die Temperatur des Referenzwiderstands (30) angepasste, temperaturkompensierte Ausgangsspannung (Umax) zur Abschaltung des Verbrauchers (10) beim Auftreten eines Überstroms im Verbraucherstromkreis (24) liefert, wobei als Referenzwiderstand (30) ein Abschnitt (46) einer Stanzgitterbahn (40) des Verbraucherstromkreises (24) dient.

7. Vorrichtung nach Anspruch 6, **dadurch gekennzeichnet, dass** der Ausgang des Referenzwiderstandes (30) über einen Verstärker (50) für die Referenzspannung (Uref) mit dem Mikroprozessor (28) verbunden ist.

8. Vorrichtung nach Anspruch 7, **dadurch gekennzeichnet, dass** der Ausgang des Verstärkers (50) für die Referenzspannung (Uref) mit einem Eingang (56a) eines Komparators (56) verbunden ist, dessen anderem Eingang (56b) von dem Mikroprozessor (28) die temperaturkompensierte Ausgangsspannung (Umax) zuführbar ist und dessen Ausgang (56c) das Steuersignal für den Verbraucher (10) beim Auftreten eines Überstroms im Verbraucherstromkreis (24) liefert.

9. Vorrichtung nach einem der Ansprüche 6 bis 9, **dadurch gekennzeichnet, dass** der Verbraucher (10) über eine mit Halbleiterschaltern, vorzugsweise mit MOSFET-Schaltern (22), aufgebaute Leistungsendstufe (20) und einen Endstufentreiber (52) mit dem Ausgang (56c) des Komparators (56) und/oder mit dem Mikroprozessor (28) verbunden ist.

10. Vorrichtung nach Anspruch 8 oder 9, **dadurch gekennzeichnet, dass** die temperaturkompensierte Ausgangsspanung (Umax) vom Mikroprozessor (28) als pulsweitenmodulierte Gleichspannung (PWM) ausgegeben wird, wobei der Ausgang (28A) des Mikroprozessors (28) über einen Tiefpass (58) mit dem Eingang (56b) des Komparators (56) verbunden ist.

11. Vorrichtung nach Anspruch 8 oder 9, **dadurch gekennzeichnet, dass** der Mikroprozessor (28) als temperaturkompensierte Ausgangsspannung (Umax) eine analoge Gleichspannung liefert, wobei der Ausgang (28b) des Mikroprozessors (28) direkt mit dem Eingang (56b) des Komparators (56) verbunden ist.

## Claims

1. Method for supplying direct current to an electrical load (10), preferably to an electric motor (10) which can be electronically commutated via a semiconductor power output stage (20) and whose load current (I) is determined according to the voltage drop (URef) across a reference resistor (30), the voltage drop (URef) in the load circuit (24) or across the load (10) itself being used as the measurement variable and subsequently being adjusted to the value of the voltage drop across a reference resistor having a very low temperature coefficient by means of temperature compensation, **characterized in that** a hardware overcurrent disconnection (50, 52, 56) is effected when a predefined voltage drop (Umax) which is cyclically adapted to the temperature of the reference resistor (30) is reached, a section (46) of a leadframe track (40) of the load circuit (24) being used as the reference resistor (30).

2. Method according to Claim 1, **characterized in that** the temperature compensation of the measurement variable is carried out computationally in a microprocessor (28).

3. Method according to one of the preceding claims, **characterized in that** at least the resistance value of that part of the circuit which is used as the reference resistor (30) and the associated reference temperature (TRef) are measured at each individual load unit, preferably when producing the circuit.

4. Method according to Claim 3, **characterized in that**, in order to approximately determine the temperature (TRef) of the reference resistor (30) during operation, the temperature of a heat sink (42), to which the reference resistor (30) is thermally and mechanically connected, is measured.

5. Method according to one of the preceding claims, **characterized in that** the values determined for the temperature compensation at the reference resistor (30) are stored in a non-volatile memory of the microprocessor (28).

6. Apparatus for supplying direct current to an electrical load (10), preferably to an electric motor (10) which can be electronically commutated via a semiconductor power output stage (20), having a reference resistor (30) in the load circuit for measuring a voltage drop (URef) corresponding to the load current (I), in particular for carrying out the method according to one of Claims 1 to 5, a part of the load circuit (24) or the load (10) itself being used as the reference resistor (30), and a microprocessor (28) being provided for the temperature compensation of the measured value (URef) according to the measured value at a reference resistor with a very low thermal voltage, which microprocessor determines the actual load current (I) from the measured voltage drop (URef) across the reference resistor (30) of the load circuit (24) taking into account its temperature, **characterized in that** a temperature sensor (32) is assigned to the reference resistor (30), and **in that** the outputs of the reference resistor (30) and of the temperature sensor (32) are connected to inputs of the microprocessor (28) which provides a temperature-compensated output voltage (Umax), which is cyclically adapted to the temperature of the reference resistor (30), for the purpose of disconnecting the load (10) when an overcurrent occurs in the load circuit (24), a section (46) of a leadframe track (40) of the load circuit (24) being used as the reference resistor (30).

7. Apparatus according to Claim 6, **characterized in that** the output of the reference resistor (30) is connected to the microprocessor (28) via an amplifier (50) for the reference voltage (Uref).

8. Apparatus according to Claim 7, **characterized in that** the output of the amplifier (50) for the reference voltage (Uref) is connected to an input (56a) of a comparator (56) whose other input (56b) can be supplied with the temperature-compensated output voltage (Umax) by the microprocessor (28) and whose output (56c) provides the control signal for the load (10) when an overcurrent occurs in the load circuit (24).

9. Apparatus according to one of Claims 6 to 9, **characterized in that** the load (10) is connected to the output (56c) of the comparator (56) and/or to the microprocessor (28) via a power output stage (20), which is constructed with semiconductor switches, preferably with MOSFET switches (22), and an output stage driver (52).

10. Apparatus according to Claim 8 or 9, **characterized in that** the temperature-compensated output voltage (Umax) is output by the microprocessor (28) in the form of a pulse-width-modulated DC voltage (PWM), the output (28A) of the microprocessor (28) being connected to the input (56b) of the comparator (56) via a low-pass filter (58).

11. Apparatus according to Claim 8 or 9, **characterized in that** the microprocessor (28) provides an analogue DC voltage as the temperature-compensated output voltage (Umax), the output (28b) of the microprocessor (28) being directly connected to the input (56b) of the comparator (56).

## Revendications

1. Procédé d'alimentation en courant continu d'une charge électrique (10), de préférence un moteur électrique (10) à commutation électronique par le biais d'un étage final de puissance à semiconducteur (20), dont le courant de charge (I) est déterminé conformément à la chute de tension (URef) aux bornes d'une résistance de référence (30), la grandeur de mesure utilisée étant la chute de tension (URef) dans le circuit électrique de charge (24) ou aux bornes de la charge (10) elle-même, laquelle est ensuite harmonisée par une compensation en température sur la valeur de la chute de tension aux bornes d'une résistance de référence ayant un très faible coefficient de température, **caractérisé en ce qu'**une déconnexion sur surintensité est réalisée physiquement (50, 52, 56) en atteignant une chute de tension (Umax) prédéfinie, adaptée de manière cyclique à la température de la résistance de référence (30), une section (46) d'une bande de grille estampée (40) du circuit électrique de charge (24) faisant office de résistance de référence (30).

2. Procédé selon la revendication 1, **caractérisé en ce que** la compensation en température de la grandeur de mesure s'effectue mathématiquement dans un microprocesseur (28).

3. Procédé selon l'une des revendications précédentes, **caractérisé en ce qu'**au moins la mesure de la valeur de la résistance de la partie du circuit utilisée comme résistance de référence (30) et de la température de référence (TRef) associée s'effectue sur chaque charge individuelle, de préférence lors de la fabrication du circuit.

4. Procédé selon la revendication 3, **caractérisé en ce que** la température d'un radiateur (42), avec lequel la résistance de référence (30) est en contact thermique et mécanique, est mesurée pour déterminer approximativement la température (TRef) de la résistance de référence (30) pendant le fonctionnement.

5. Procédé selon l'une des revendications précédentes, **caractérisé en ce que** les valeurs déterminées sur la résistance de référence (30) pour la compensation en température sont stockées dans une mémoire non volatile du microprocesseur (28).

6. Dispositif d'alimentation en courant continu d'une charge électrique (10), de préférence un moteur électrique (10) à commutation électronique par le biais d'un étage final de puissance à semiconducteur (20), comprenant une résistance de référence (30) dans le circuit électrique de charge pour mesurer une chute de tension (URef) correspondant au courant de charge (I), notamment pour mettre en oeuvre le procédé selon l'une des revendications 1 à 5, une partie du circuit électrique de charge (24) ou la charge (10) elle-même servant de résistance de référence (30) et un microprocesseur (28) étant prévu pour la compensation en température de la valeur mesurée (URef) en fonction de la valeur mesurée sur une résistance de référence avec une très faible contrainte thermique, lequel détermine le courant de charge (I) effectif à partir de la chute de tension mesurée (URef) aux bornes de la résistance de référence (30) du circuit électrique de charge (24) en tenant compte de sa température, **caractérisé en ce qu'**une sonde de température (32) est associée à la résistance de référence (30) et que les sorties de la résistance de référence (30) et de la sonde de température (32) sont reliées avec des entrées du microprocesseur (28), lequel délivre une tension de sortie (Umax) compensée en température et adaptée de manière cyclique à la température de la résistance de référence (30) pour déconnecter la charge (10) en présence d'une surintensité dans le circuit électrique de charge (24), une section (46) d'une bande de grille estampée (40) du circuit électrique de charge (24) faisant office de résistance de référence (30).

7. Dispositif selon la revendication 6, **caractérisé en ce que** la sortie de la résistance de référence (30) est reliée au microprocesseur (28) par le biais d'un amplificateur (50) pour la tension de référence (URef).

8. Dispositif selon la revendication 7, **caractérisé en ce que** la sortie de l'amplificateur (50) qui délivre la tension de référence (URef) est reliée à l'entrée (56a) d'un comparateur (56) à l'autre entrée (56b) duquel peut être acheminée depuis le microprocesseur (28) la tension de sortie (Umax) compensée en température et dont la sortie (56c) délivre le signal de commande pour la charge (10) en présence d'une surintensité dans le circuit électrique de charge (24).

9. Dispositif selon l'une des revendications 6 à 9, **caractérisé en ce que** la charge (10) est reliée à la sortie (56c) du comparateur (56) et/ou au microprocesseur (28) par le biais d'un étage final de puissance (20) constitué de commutateurs à semiconducteur, de préférence des commutateurs MOSFET (22), et d'un circuit d'attaque d'étage final (52).

10. Dispositif selon la revendication 8 ou 9, **caractérisé en ce que** la tension de sortie (Umax) compensée en température du microprocesseur (28) est délivrée sous la forme d'une tension continue modulée en largeur d'impulsion (PWM), la sortie (28A) du microprocesseur (28) étant reliée à l'entrée (56b) du comparateur (56) par le biais d'un filtre passe-bas (58).

11. Dispositif selon la revendication 8 ou 9, **caractérisé en ce que** le microprocesseur (28) délivre comme tension de sortie (Umax) compensée en température une tension continue analogique, la sortie (28b) du microprocesseur (28) étant reliée directement à l'entrée (56b) du comparateur (56).
